# EUROPEAN PATENT SPECIFICATION

(11) **EP 2 884 366 B1**
(45) Date of publication and mention of the grant of the patent: **10.10.2018**
(21) Application number: 13197006.3
(22) Date of filing: 12.12.2013
(51) Int. Cl.: G06F 1/04, G06F 1/12, H03K 5/131, H03L 7/081, H04L 7/00

(54) **Self-adjusting delay circuit**
Selbsteinstellende Verzögerungsschaltung
Circuit à retard autoréglable

(43) Date of publication of application: 17.06.2015
(73) Proprietor: ROHM CO., LTD., Kyoto 615-8585 (JP)
(72) Inventor: Mladenova, Irina, Ukyo-ku, Kyoto 615-8585 (JP)
(74) Representative: Isarpatent

(56) References cited:
- GB-A- 2 359 706
- US-A1- 2001 054 922
- US-A1- 2004 150 438
- US-A1- 2005 030 076
- US-A1- 2013 257 502

## Description

The invention relates to an apparatus for self-adjustment of a received clock signal provided for a received data signal.
Integrated circuits, in particular VLSI circuits, can contain several thousands of latches so that the total wire length of a clock signal supply line can exceed several millimetres within the integrated chip. The clock frequency of a clock signal is in many applications maximized to achieve a high-system performance of the integrated circuit. A combination of a relatively high clock frequency and a large clock load can cause severe timing problems.
In many chip designs, pipeline or scan registers integrated in the circuit are implemented by using serial connections of flip-flops. Especially, in a scan mode during testing of the integrated circuit, flip-flops can be directly connected to other flip-flops. This direct connection between the flip-flops results in that the propagation time of the data between these flip-flops is also very short. Since the clock signal is routed through these blocks automatically, its time of arrival at the first flip-flop of a different logic block can be earlier than the arrival time of the corresponding data signal. This can occur also when the input pads or paths of the data signal and clock signal have different delays or when these signals are applied from external signal sources in an incorrect manner, for example if the data set-up time does not satisfy the requirements of the respective flip-flops which have to latch the corresponding data. In these cases, it is necessary to delay the clock signal so that a proper data sampling can be guaranteed. For this purpose, delay circuits are used.

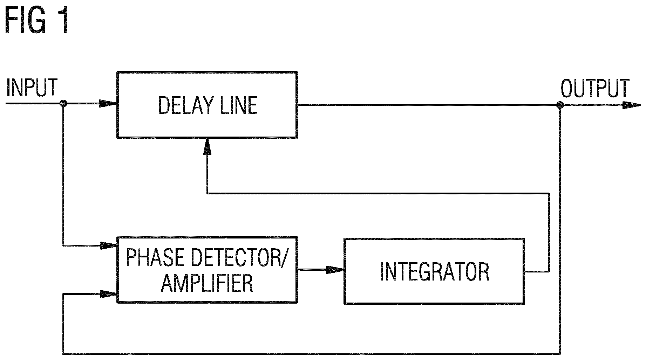

Fig. 1 shows a circuit diagram of a conventional delay circuit comprising a delay-locked loop DLL. The delay circuit illustrated in Fig. 1 comprises a delay line which can include some inverters and an integrating chain (RC-delay). The delay of the delay line can be controlled by the output voltage of an integrator as shown in Fig. 1. For the RC-delay line, a main disadvantage of the conventional delay circuit shown in Fig. 1 is that the delay provided by the delay line is dependent on the used manufacturing process technology. Depending on the employed technology process the provided delay of the delay line can vary between 10 and 100%. In many applications, this wide variation delay is unacceptable. The delay circuit shown in Fig. 1 further comprises a phase detector/amplifier. For the delay line used in the delay-locked loop as shown in Fig. 1, a delay of the DLL circuit is susceptible to supply noise which can in some cases depend on supply voltage variations within a supply voltage range.

Prior art delay circuits are described in the documents US 2004/150438 and US 2001/054922.

Accordingly, it is an object of the present invention to provide an apparatus which provides an adjustable delay with a minimal delay variation.

This object is achieved according to the present invention by a self-adjusting delay circuit according to claim 1.

In a possible embodiment of the self-adjusting delay circuit according to the present invention, the clock edge counter is a ripple counter comprising a predetermined number of flip-flops connected in series to each other.
In a further possible embodiment of the self-adjusting delay circuit according to the present invention, the inverters of the adjustable delay line are three-state inverters each being enabled by a bit of the n-bit counter value output by the clock edge counter to invert the received clock signal with a driving current strength corresponding to the significance of the respective enabling bit.

In a still further possible embodiment of the self-adjusting delay circuit according to the present invention, a reset detector circuit is provided adapted to generate in response to a reset signal a single pulse to set the flip-flops of the clock edge counter.
In a further possible embodiment of the self-adjusting delay circuit according to the present invention, a clock edge detector circuit is provided adapted to detect falling and/or rising signal edges of the received clock signal.
In a further possible embodiment of the self-adjusting delay circuit according to the present invention, the reset detector circuit and the clock edge detector circuit are connected via an OR gate to a clock input of the clock edge counter.
In a further possible embodiment of the self-adjusting delay circuit according to the present invention, an output of the edge comparator is set if the rising signal edge of the received data signal appears before a rising signal edge of the delayed clock signal output by the adjustable delay line.

In a still further possible embodiment of the self-adjusting delay circuit according to the present invention, the edge comparator disables directly or via the phase margin security circuit the clock edge detector circuit as soon as the rising signal edge of the received data signal precedes the rising signal edge of the delayed clock signal output by the adjustable delay line.
In a further possible embodiment of the self-adjusting delay circuit according to the present invention, the received data signal is forwarded directly or via a buffer circuit of said self-adjusting delay circuit.
In a further possible embodiment of the self-adjusting delay circuit according to the present invention, the clock edge counter, the edge comparator and the phase margin security circuit comprise the same type of flip-flops.

In a further possible embodiment of the self-adjusting delay circuit according to the present invention, the flip-flops of the clock edge counter, the edge comparator and the phase margin security circuit comprise D-flip-flops.

In a further possible embodiment a delay-locked loop circuit comprises a self-adjusting delay circuit according to the present invention.

In the following, possible embodiments of the present invention are described with reference to the enclosed figures in more detail.
- Fig. 1: shows a conventional delay-locked loop illustrating a problem underlying the present invention;
- Fig. 2: shows a circuit diagram for illustrating a possible exemplary embodiment of a self-adjusting delay circuit according to the first aspect of the present invention;
- Fig. 3: shows a circuit diagram of an adjustable delay line according to a possible embodiment of the present invention;
- Fig. 4: shows a circuit diagram of a possible exemplary implementation of a clock edge counter used in a possible embodiment of self-adjusting delay circuit according to the present invention;
- Fig. 5: shows a circuit diagram of a three-state inverter which can be used within an adjustable delay line in a possible exemplary embodiment of the present invention;
- Fig. 6: shows signal diagrams for illustrating the operation of a self-adjusting delay circuit in a possible exemplary implementation.

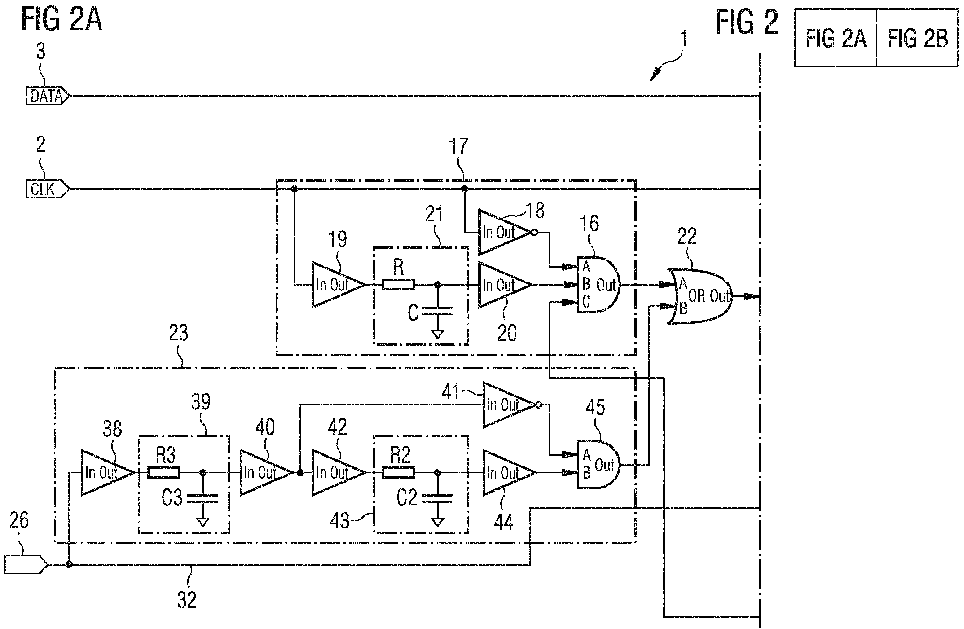

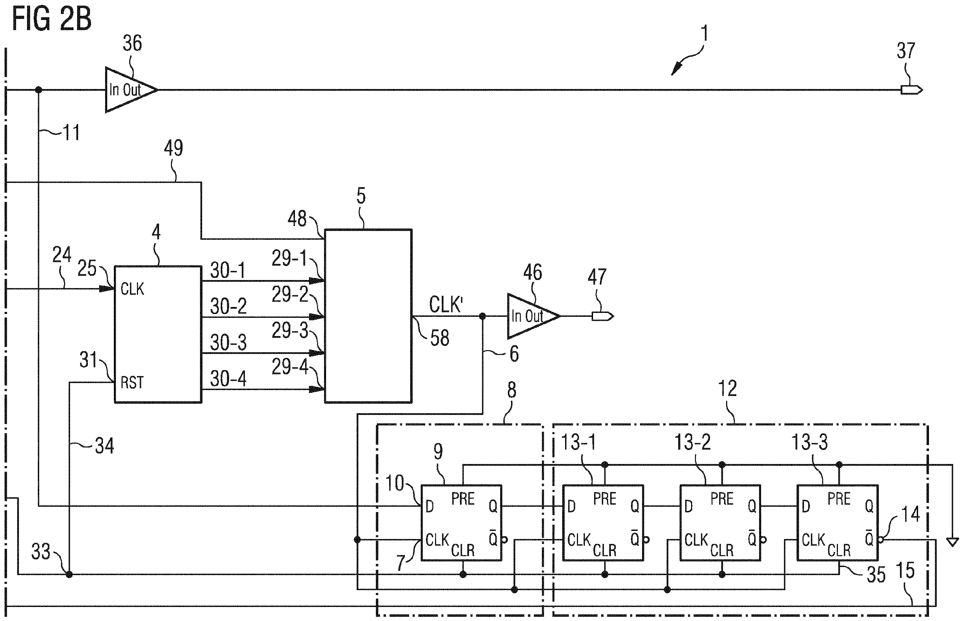

As can be seen in the circuit diagram of Fig. 2, in the shown exemplary embodiment, the self-adjusting delay circuit 1 according to the first aspect of the present invention is adapted to delay a received clock signal CLK applied to a clock input 2 provided for a received data signal (data) received at a data input 3 of the self-adjusting delay circuit 1. In the shown exemplary embodiment, the self-adjusting delay circuit 1 comprises a clock edge counter 4 adapted to count signal edges (e.g. falling signal edges) of the received clock signal CLK. The clock edge counter 4 is adapted to provide an incremented n-bit counter value applied to an adjustable delay line 5 having a corresponding number of inverters connected to each other in parallel, wherein each inverter is enabled by an associated bit of the n-bit counter value applied by the clock edge counter 4 to invert the received clock signal CLK with a driving current strength of the inverter corresponding to the significance of the respective bit of the n-bit counter value to load at least one capacitor of the adjustable delay line 5. In the shown exemplary embodiment, the clock edge counter 4 applies an incremented 4-bit counter value to an adjustable delay line 5 having a corresponding number of inverters being connected to each other in parallel and being connected in parallel to an inverter receiving directly the clock signal CLK applied to the input 2 of the self-adjusting delay circuit 1.

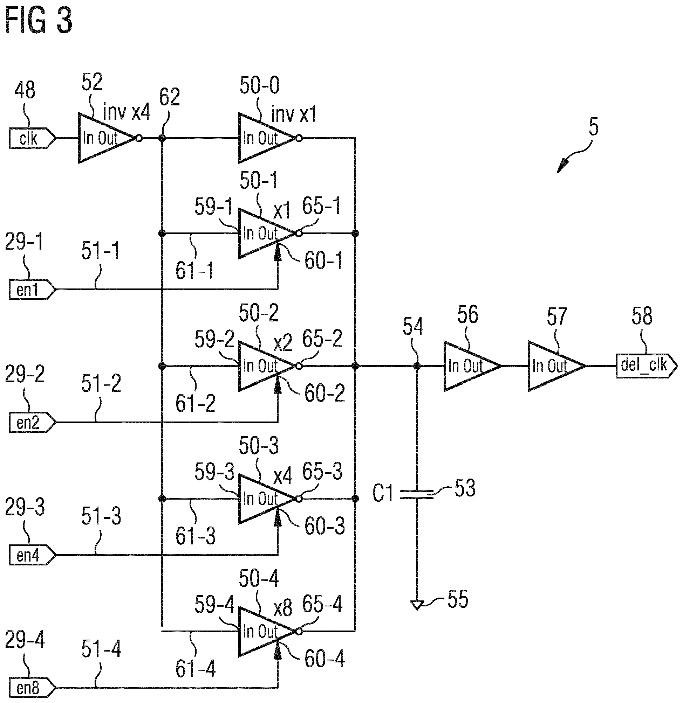

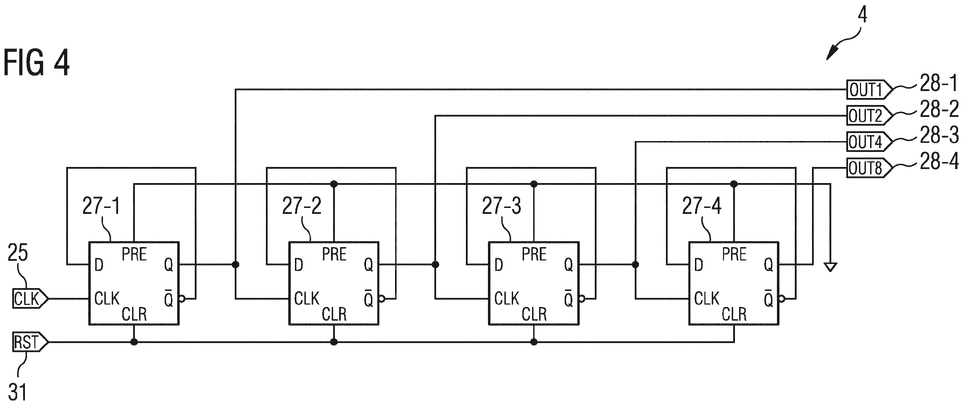

Fig. 3 shows a circuit diagram of an exemplary embodiment of the adjustable delay line 5 connected to the output of a clock edge counter 4. The clock edge counter 4 can be in a possible embodiment be a ripple counter comprising a predetermined number of flip-flops connected in series to each other as illustrated in the circuit diagram of Fig. 4. In the self-adjusting delay circuit 1 as shown in Fig. 2, the received clock signal CLK is delayed by the adjustable delay line 5 with a stepwise increasing time delay, wherein the time delay is proportional to the incremented n-bit counter value output by the clock edge counter 4 until an edge comparator detects that a rising signal edge of the received data signal (data) precedes a rising signal edge of the delayed clock signal (CLK') output by the adjustable delay line 5.
As shown in Fig. 2, the output of the adjustable delay line 5 is connected via a clock signal line 6 to a clock input 7 and an edge comparator 8 which comprises in the shown exemplary embodiment a D-flip-flop 9 having a data input 10 receiving the data signal (data) via a signal line 11. The edge comparator 8 compares the signal edges of the received data signal (data) with the signal edges of the delayed clock signal CLK' output by the adjustable delay line 5 to detect when a rising signal edge of the received data signal precedes a rising signal edge of the delayed clock signal CLK'. The received clock signal CLK is delayed by the adjustable delay line 5 with an increasing time delay being proportional to the incremented n-bit counter value output by the clock edge counter 4 until the edge comparator 8 detects that a rising signal edge of the received data signal precedes a rising signal edge of the delayed clock signal CLK'. The D-flip-flop 9 comprises an output 11 wherein said output is set if the rising signal edge of the received data signal appears before a rising signal edge of the delayed clock signal output by the adjustable delay line 5.
In the shown embodiment of Fig. 2, a phase margin security circuit 12 is provided which comprises a predetermined number of flip-flops connected in series to each other. The phase margin security circuit 12 is provided to secure a phase margin and consists in the shown exemplary embodiment of three flip-flops 13-1, 13-2, 13-3. In the shown exemplary embodiment, the flip-flops 13-i of the phase margin security circuit 12 are formed by D-flip-flops each having a clock input connected to the clock signal line 6 and receiving the delayed clock signal CLK' output by the adjustable delay line 5. Each D-flip-flop 13-i of the phase margin security circuit 12 has a data input (D) connected to the output of the preceding flip-flop 13-(i-1), wherein the first flip-flop 13-1 of the phase margin security circuit 12 is connected to the output 11 of the D-flip-flop forming the edge comparator 8. In a possible embodiment, each D-flip-flop 9, 13-i comprises a preset input PRE for settings and a clear input CLR for resetting the flip-flops. In the shown embodiment of Fig. 2, the edge comparator 8 and the phase margin security circuit 12 are implemented by using the same type of flip-flops, i.e. D-flip-flops. In the shown exemplary embodiment of Fig. 2, the phase margin security circuit 12 comprises three flip-flops, but the number of flip-flops can vary depending on the requirements of the set-up time. In the phase margin security circuit 12, a predetermined number of flip-flops is connected in series to each other, wherein the inverted output 14 of the last flip-flop supplies a counter stop signal in the shown embodiment via a signal line 15 to an AND gate 16 of a clock edge detector circuit 17 as shown in Fig. 2.
The clock edge detector circuit 17 is adapted to detect in the shown exemplary embodiment falling signal edges of the received clock signal CLK applied to the input 2 of the self-adjusting delay circuit 1. The clock edge detector a... .. 17 comprises the AND gate 16 having three inputs A, B, C, wherein the third input C receives via the signal line 15 a count stop signal from the output of the phase margin security circuit 12. The first input A of the AND gate 16 within the clock edge detector circuit 17 receives the received clock signal CLK directly via an inverter circuit 18. The second input B of the AND gate 16 receives the clock signal CLK via two buffer circuits 19, 20 comprising a RC-delay circuit 21 in-between. The RC delay circuit 21 comprises in the shown exemplary embodiment a resistor R with a predetermined resistance and a capacitor C with a predetermined capacitance. In a possible embodiment, the resistance of the resistor within the RC delay circuit 21 and the capacitance of the capacitor within RC delay the circuit 21 can be adjustable.
The output of the AND gate 16 within the clock edge detector circuit 17 is connected to a first input of an OR gate 22 having a second input connected to the output of a reset detector circuit 23. The output of the OR gate 22 is connected via a line 24 to an clock input 25 of the clock edge counter 4 as also illustrated in Fig. 4.
The reset detector circuit 23 is adapted to generate in response to a reset signal RST applied to a reset input 26 of the self-adjusting delay circuit 1 a signal pulse to set all flip-flops within the clock edge counter 4.
In the shown embodiment of Fig. 4, the clock edge counter 4 comprises a ripple counter. The ripple counter shown in Fig. 4 comprises four flip-flops 27-1, 27-2, 27-3, 27-4 to count detected signal edges of the received clock signal CLK to provide an incremented n-bit counter value at output terminals 28-1, 28-2, 28-3, 28-4 connected to corresponding inputs 29-1, 29-2, 29-3, 29-4 via parallel signal lines 30-1, 30-2, 30-3, 30-4 as illustrated in Fig. 2. In the shown exemplary embodiment, the clock edge counter 4 comprises four D-flip-flops and generates an incremented 4-bit counter value applied to the adjustable delay line 5 having a corresponding number of n=4 inverters being connected to each other in parallel and enabled by a corresponding bit of the n-bit counter value as also illustrated in Fig. 3. In the shown exemplary embodiment, the first bit of the ripple counter value output at terminal 28-1 has the lowest bit significance, whereas the bit output by the last serial connected D-flip-flop 27-4 output at terminal 28-4 has the highest bit significance. Each D-flip-flop 27-i of the clock edge counter 4 comprises a clock input being connected to the data output of the previous flip-flop. The data input D of each D-flip-flop 27-i is connected to the inverted data output *Q̅* of the same flip-flop. Further, each D-flip-flop comprises a preset input PRE connected to a fixed potential and a clear input CLR connected to a reset input 31 of the clock edge counter 4 as illustrated in Fig. 4. An asynchron ripple counter as shown in Fig. 4 is an asynchronous counter having a first flip-flop 27-1 being clocked by the external clock signal CLK. All subsequent flip-flops 27-i are clocked by the output of the preceding flip-flop. The MOD of the ripple counter is 2ⁿ when n-flip-flops are used. For a 4-bit ripple counter, the count range of the count value is 0000 to 1111. In a possible embodiment, the counter value is incremented stepwise, wherein the count sequence does repeat itself. There are different ways to implement the ripple counter 4 depending on the characteristics of the used flip-flops and the requirements of the respective count sequence. In the shown exemplary embodiment of Fig. 4, the ripple counter is implemented by using D-flip-flops. In other embodiments, it is also possible to use different kinds of flip-flops such as JK-flip-flops. Further, it is possible to use as a clock trigger a positive edge or a negative signal edge. Further, it is possible to vary the count direction between counting up and counting down.
In the shown embodiment of Fig. 2, the self-adjusting delay circuit 1 has a reset input terminal 26 which is connected via a reset line 32 to a node 33 being connected via a reset line 34 to the reset input 31 of the clock edge counter 4 and via a reset line 35 to the clear inputs CLR of the D-flip-flops within the edge comparator 8 and the phase margin security circuit 12 as illustrated in Fig. 2.
As can be seen in Fig. 2, the clock edge detector circuit 17 and the reset detector circuit 23 are both connected via the OR gate 22 to the clock input 25 of the clock edge counter 4. The edge comparator 8 enables in the shown embodiment via the phase margin security circuit 12 the clock edge detector circuit 17 as soon as the rising signal edge of the received data signal (data) precedes the rising signal edge of the delayed clock signal CLK' output by the adjustable delay line 5. The received data signal applied to the data input 3 of the self-adjusting delay circuit 1 is in a possible embodiment forwarded directly. In the embodiment shown in Fig. 2, the received data signal is forwarded via a buffer circuit 36 to a data output terminal 37 of the self-adjusting delay circuit 1.
In the shown exemplary embodiment of Fig. 2, the reset detector circuit 23 comprises a first buffer circuit 38 connected via an RC delay circuit 39 to a second buffer circuit 40 whose output is connected to the input of an inverter circuit 41 and to an output of a further buffer circuit 42. The output of the buffer circuit 42 is connected via a further RC delay circuit 43 to the input of a buffer circuit 44. The output of the inverter circuit 41 and the output of the buffer circuit 44 are connected to corresponding inputs of an AND gate 45 of the reset detector circuit 23. The output of the AND gate 45 is connected with the second input of the OR gate 22 as illustrated in Fig. 2.
In the shown embodiment of Fig. 2, the delayed clock signal CLK' output by the adjustable delay line 5 is applied via a buffer circuit 46 to a clock output terminal 47 for the delayed clock signal output by the self-adjusting delay circuit 1.

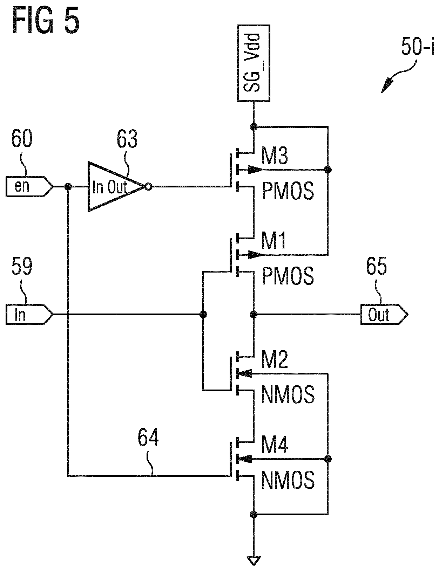

Fig. 5 shows a possible exemplary embodiment of the adjustable delay line 5 within the self-adjusting delay circuit 1. In the shown embodiment, the adjustable delay line 5 comprises a clock input 48 connected via a clock line 49 to the clock input 2 of the self-adjusting delay circuit 1. Accordingly, the clock input 48 receives directly the applied clock signal CLK. In the shown embodiment, the adjustable delay line 5 comprises a number of inverters 50-1, 50-2, 50-3, 50-4 being connected to each other in parallel and being enabled by a corresponding bit of the n-bit counter value received from the clock edge counter 4. As can be seen in Fig. 3, each of the parallel inverters 50-i is enabled via an internal line 51-i connected to an enabling bit input terminal 29-i of the adjustable delay line 5. The adjustable delay line 5 further comprises an inverter 50-0 whose input is connected via an inverter 52 to the clock input 48 of the adjustable delay line 5. The inverters 50-i are connected to each other in parallel, as illustrated in Fig. 3. The inverters 50-1, 50-2, 50-3, 50-4 are enabled by an associated bit of the n-bit counter value to invert the received clock signal, wherein the driving current strength of the respective inverter does correspond to the bit-significance of the respective bit of the n-bit counter value to load a capacitor 53 of the adjustable delay line 5. In the shown exemplary embodiment, the inverter 50-1 is enabled by the bit of the counter value having the least significance (LSB) and the inverter 50-4 is enabled by the bit of the counter value having the highest or most significance (MSB). Accordingly, in the shown embodiment, the lowest significant bit LSB of the counter value enables the inverter 50-1, wherein the most significant bit MSB enables the inverter 50-4 with the highest current driving strength. In the shown exemplary embodiment, the inverter 50-1 has a current driving strength of 2°=1, the second inverter 50-2 has a current driving strength of 2¹=2, the third inverter 50-3 has a driving strength of 2²=4 and the fourth inverter 50-4 has a driving strength of 2³=8. The inverters 50-0 has in the shown exemplary embodiment a predetermined driving strength of 4 corresponding to the driving strength of the inverter 52 and corresponding to the number of bits of the n-bit counter value. In the shown embodiment, the capacitor 53 has a predetermined capacitance of 1 p^{F}. The time delay provided by the adjustable delay line 5 depends on the driving strength of the inverters and the capacitance C of the capacitor 53. The outputs of the inverters 50-0 to 50-4 are all connected to a common node 54. The capacitor 53 is connected between the common node 54 and a node 55 at a predetermined potential as illustrated in Fig. 3. In the shown exemplary embodiment, node 54 is connected via two serial connected buffer circuits 56, 57 to the clock output 58 of the adjustable delay line 5 supplying a delayed clock signal CLK' via the buffer circuit 46 to the output clock terminal 57 of the self-adjusting delay circuit 1. Further, the delayed clock signal CLK' is applied via the clock line 6 to the edge detector circuit 8 and the phase margin security circuit 12.

Fig. 5 shows a circuit diagram of an exemplary embodiment of a three-state inverter which can be used in the adjustable delay line 5 for the inverter circuits 50-1, 50-2, 50-3, 50-4. As can be seen in Fig. 5, each three-state inverter 50-i comprises a signal input 59 and an enable control input 60. The signal input 59 is connected within the adjustable delay line 5 via a corresponding internal line 61 to a common node 62 to receive the inverted clock signal. The enable control input 60 is connected via internal control lines 51-1, 51-i to a corresponding control input 29-i of the adjustable delay line 5. The three-state inverter 50-i comprises an internal inverter 63 connected to the gate of a PMOS M3. The enable control input 60 is connected via the internal inverter 63 to the control gate of the PMOS M3 and directly via an internal line 64 to the gate of an NMOS M4. The signal input 59 connected to the node 62 is applied to the gate of a PMOS M1 and to the gate of a complementary NMOS M2 as illustrated in Fig. 5. The three-state inverter 50-i illustrated in Fig. 5, inverts the received signal applied to the signal input 59 with a predetermined current strength of the internal inverter 63, if the enable control input 60 receives an enabling signal, i.e. a bit of the n-bit counter value. The output 65 of the three-state inverter 50-i is connected to node 54 of the adjustable delay line 5 shown in Fig. 3.
The self-adjusting delay circuit 1, as shown in the embodiment of Fig. 2 comprises four main sub-blocks including the adjustable delay line 5, the clock edge counter 4, the clock edge detector circuit 17 and the phase margin security circuit 12 which secures a predetermined phase or time margin. The clock edge counter 4 in the embodiment shown in Fig. 2 comprises a 4-bit counter, but it can be in different embodiments of different size depending on the desired precision. The number of the counter bits of the n-bit counter value defines a correction step size, step number and correction range. The phase margin security circuit 12 secures the phase margin comprising in the shown embodiment of Fig. 2 three flip-flops, but their number can be increased as well depending on the requirements for a set-up time. The edge comparator 8 can use the same type of flip-flops as the phase margin security circuit 12. Some additional logic is used to adjust delays for the signal. In a possible embodiment, these logic blocks can be placed in the input pads. All other sub-blocks of the self-adjusting delay circuit 1 can be placed in a possible embodiment close to the shift register or latch for which these inputs form the signal shape.
At a power-up sequence, a reset of all flip-flops is done. On outputs 28-i of the clock edge counter 4 a low bit value "0" is provided. The falling edge of the POR (Power on Reset) signal by use of the falling edge detector creates a short pulse which through the OR gate 22 is applied to the clock input 25 of the clock edge counter 4. Thus, after the POR signal has been generated, all flip-flops are set to a logical high value "1" at their outputs. In this way, all three-state inverters 50-i of the adjustable delay line 5 are enabled and the resulting delay of the adjustable delay line 5 is small. For adjusting the delay of the self-adjusting delay line after the start-up, a sequence of RZ (Return Zero) only "1" is applied at the data input. This data is also applied to the data input of the edge detector. The clock signal CLK' delayed by the adjustable delay line 5 is applied to the clock input 7 of the edge comparator 8. If the set-up time is not enough, the edge comparator 8 samples a logical low value "0". The following clock period causes a change in the counter status. It enables an inverter with a lower driving capability and disables one with a higher driving capability so that the total strength of the parallel connected three-state inverters is reduced slightly and the delay of the adjustable delay line 5 increases. The edge comparator 8 comprising the D-flip-flop 9 is clocked now with a slightly more delayed clock signal. If the set-up time is still not enough, this process is repeated until the set-up time becomes sufficient to trigger the flip-flop 9 of the edge comparator 8. The logical high value "1" which does appear on its output is sampled by the phase margin security circuit 12. After two clock periods, the sampled signal appears at the circuitry output of the phase margin circuit 12. The inverted signal gates further the clock signal for the clock edge counter 4 which keeps its state until the power-down of the chip. A few additional delay steps create a security margin needed because of the noise and the possible clock jitter of the clock signal. In case that two clock periods (two adjustment steps) are not provided with enough security margin, it is possible to add further flip-flops in a pipeline within the phase margin security circuit 12. To achieve the desired phase margin, each flip-flop can add one adjustment step to the margin (4-bit counter in the self-adjusting delay line 5 corresponds to 16 adjustment steps).
When the self-adjustment process stops (with enough phase margin for the set-up time), the gated clock signal stops at the input of the clock edge counter 4 and thus remains in this status keeping the adjustable delay line 5 adjusted with the necessary fitting time delay. It is possible that the value is recorded in the counter giving an optimal delay time. This optimal delay time can be written in an OTP (One Time Programmable) to program the adjustable delay line 5.

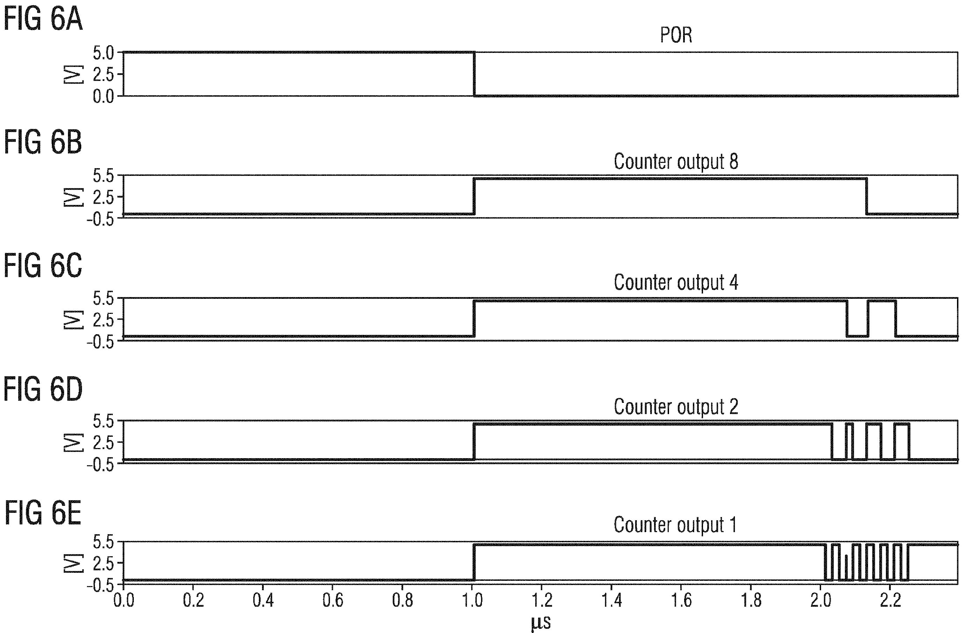

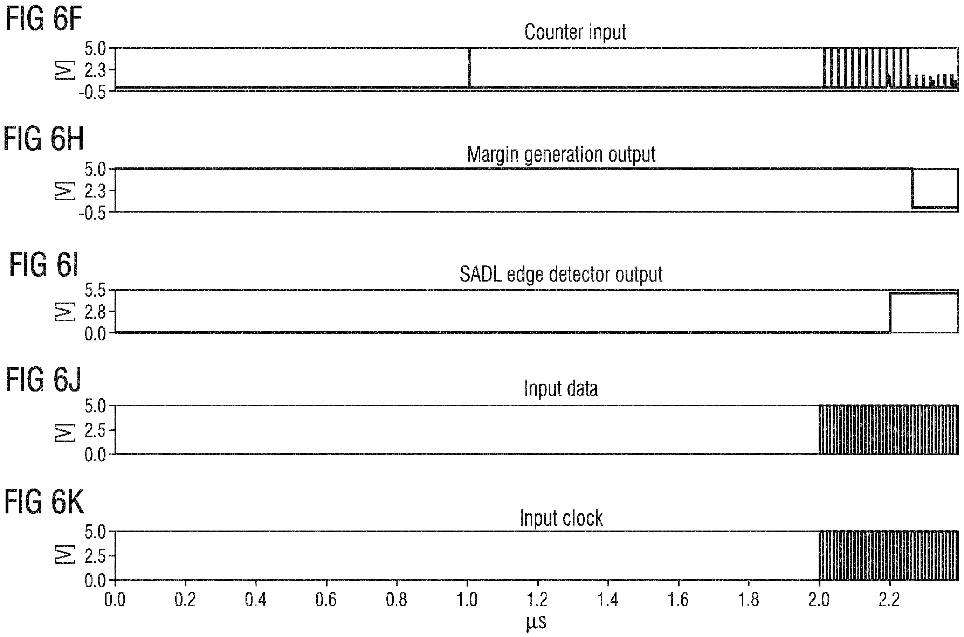

Fig. 6 shows signal diagrams for illustrating the operation of a self-adjusting delay circuit 1 according to the present invention as illustrated in Fig. 2. Fig. 6A shows the power on reset (POR) signal making a short pulse which through the OR gate 22 is applied to the clock input 25 of the clock edge counter 4. Figs. 6B, 6C, 6D, 6E illustrate different counter output bits of a 4-bit clock edge counter 4, as shown in the embodiment of Fig. 2. Fig. 6F illustrates the counter input signal. Fig. 6H shows the margin generation output by the phase margin security circuit 12 of the self-adjusting delay circuit 1. Fig. 6I shows the SADL edge detector output of the edge comparator 8. Fig. 6J illustrates input data and Fig. 6K illustrates a corresponding input clock signal.
With the self-adjusting delay circuit 1 according to the present invention it is possible that the time delay of the adjustable delay line 5 is adjusted for different technology process parameters. Moreover, the delay of the delay line can be adjusted for different power supply voltages. The adjustment of the delay guarantees that each received data packet or data can be sampled correctly. The power consumption of the self-adjusting delay circuit 1 after adjustment is equal to a conventional RC-delay line. Accordingly, no additional power is required and the self-adjusting delay circuit 1 does not consume more electrical power than conventional delay lines. The self-adjusting delay circuit 1 according to the present invention can handle process variations and parasitic elements caused by the circuit design. Whereas conventional delay lines are hard-wired and cannot be adapted, the delay circuit according to the present invention is self-adjusting. The self-adjusting delay circuit 1 according to the present invention can be used in any circuits to delay a clock signal guaranteeing in this way a set-up time independently on the power supply range and the technology parameter variations.

## Claims

1. A self-adjusting delay circuit (1) adapted to delay a received clock signal (CLK) provided for a received data signal (data),
said self-adjusting delay circuit (1) comprising:
a clock edge counter (4) adapted to count signal edges of the received clock signal (CLK) providing an incremented n-bit counter value at output terminals (28-i) connected to corresponding inputs (29-i) of an adjustable delay line (5) of said self-adjusting delay circuit (1) via parallel signal lines (30-i), said adjustable delay line (5) having a number (n) of inverters (50-i) being connected to each other in parallel,
wherein each inverter (50-i) of said adjustable delay line (5) is enabled by an associated bit of the n-bit counter value received from said clock edge counter (4) via the parallel signal lines (30-i) to invert the received clock signal (CLK) with a driving current strength of the inverter (50-i) corresponding to the significance of the respective bit of said n-bit counter value to load a capacitor (53) of said adjustable delay line (5) connected to the outputs of the inverters (50-i),
wherein the driving current strength of the i-th inverter (50-i) of said adjustable delay line (5) is 2ⁱ⁻¹ with 1≤i≤n, said self-adjusting delay circuit (1) further comprising:
- an edge comparator (8) formed by a flip-flop (9) having a clock input (7) receiving the delayed clock signal (CLK') output by a clock output (58) of said adjustable delay line (5) and having a data input (10) receiving the data signal (data) and
- a phase margin security circuit (12) for providing a phase margin security against clock jitter of the received clock signal (CLK), said phase margin security circuit (12) comprising a predetermined number of flip-flops (13-i) connected in series to each other,
wherein the first flip-flop (13-1) of said phase margin security circuit (12) is connected to an output (11) of the flip-flop (9) of said edge comparator (8),
wherein the received clock signal (CLK) is delayed by said adjustable delay line (5) with an increasing time delay proportional to the incremented n-bit counter value output by said clock edge counter (4) until said edge comparator (8) detects that a rising signal edge of the received data signal (data) precedes a rising signal edge of the delayed clock signal (CLK') output by the clock output (58) of said adjustable delay line (5) including a time margin provided by said phase margin security circuit (12).

2. The self-adjusting delay circuit according to claim 1,
wherein the clock edge counter (4) is a ripple counter comprising a predetermined number (n) of flip-flops (27-i) connected in series to each other.

3. The self-adjusting delay circuit according to claim 1 or 2,
wherein the inverters (50-1, 50-2, 50-3, 50-4) of the adjustable delay line (5) are three-state inverters each being enabled by a bit of the n-bit counter value output by said clock edge counter (4) adapter to invert the received clock signal (CLK) with a driving current strength corresponding to the significance of the respective enabling bit.

4. The self-adjusting delay circuit according to one of the preceding claims 1 to 3, comprising
a reset detector circuit (23) adapted to generate in response to a reset signal (RST) a single pulse to set flip-flops of said clock edge counter (4).

5. The self-adjusting delay circuit according to one of the preceding claims 1 to 4, comprising
a clock edge detector circuit (17) adapted to detect falling signal edges of the received clock signal (CLK).

6. The self-adjusting delay circuit according to claim 5 when dependent on claim 4, wherein the reset detector circuit (23) and the clock edge detector circuit (17) are connected via an OR gate (22) to a clock input (25) of said clock edge counter (4).

7. The self-adjusting delay circuit according to one of the preceding claims 1 to 6,
wherein the output (11) of said edge comparator (8) is set if the rising signal edge of the received data signal (data) appears before a rising signal edge of the delayed clock signal (CLK') output by the adjustable delay line (5) .

8. The self-adjusting delay circuit according to one of the preceding claims 5 to 6, or according to claim 7 when dependent on one of the claims 5 to 6, wherein said edge comparator (8) is adapted to disable directly or via said phase margin security circuit (12) the clock edge detector circuit (17) as soon as the rising signal edge of the received data signal precedes the rising signal edge of the delayed clock signal (CLK') output by said adjustable delay line (5).

9. The self-adjusting delay circuit according to one of the preceding claims 1 to 8,
wherein the received data signal (data) is forwarded directly or via a buffer circuit (36) of said self-adjusting delay circuit (1).

10. The self-adjusting delay circuit according to one of the preceding claims 1 to 9,
wherein said clock edge counter (4), said edge comparator (8) and said phase margin security circuit (12) comprise the same type of flip-flops.

11. The self-adjusting delay circuit according to claim 10,
wherein the flip-flops of said clock edge counter (4), said edge comparator (8) and said phase margin security circuit (12) comprise D-flip-flops.

12. A delay locked loop (DLL) circuit comprising a self-adjusting delay circuit (1) according to one of the preceding claims 1 to 11.

## Patentansprüche

1. Selbsteinstellender Verzögerungsschaltkreis (1), der dafür ausgelegt ist, ein empfangenes Taktsignal (CLK) zu verzögern, das für ein empfangenes Datensignal (Daten) bereitgestellt wird,
wobei der selbsteinstellende Verzögerungsschaltkreis (1) Folgendes umfasst:
einen Taktflankenzähler (4), der dafür ausgelegt ist, Signalflanken des empfangenen Taktsignals (CLK) zu zählen, so dass ein inkrementierter n-Bit-Zählerwert an Ausgangsanschlüssen (28-i) bereitgestellt wird, die mit entsprechenden Eingängen (29-i) einer einstellbaren Verzögerungsleitung (5) des selbsteinstellenden Verzögerungsschaltkreises (1) über parallele Signalleitungen (30-i) verbunden sind,
wobei die einstellbare Verzögerungsleitung (5) eine Anzahl (n) von Invertern (50-i) aufweist, die miteinander parallel geschaltet sind, wobei jeder Inverter (50-i) der einstellbaren Verzögerungsleitung (5) durch ein verknüpftes Bit des n-Bit-Zählerwertes aktiviert wird, der von dem Taktflankenzähler (4) über die parallelen Signalleitungen (30-i) empfangen wird, um das empfangene Taktsignal (CLK) mit einer Ansteuerungsstromstärke des Inverters (50-i) zu invertieren, die der Wertigkeit des jeweiligen Bits des n-Bit-Zählerwertes entspricht, um einen Kondensator (53) der einstellbaren Verzögerungsleitung (5) zu laden, der mit den Ausgängen der Inverter (50-i) verbunden ist,
wobei die Ansteuerungsstromstärke des i-ten Inverters (50-i) der einstellbaren Verzögerungsleitung (5) 2¹⁻¹ ist, wobei 1≤i≤n, wobei der selbsteinstellende Verzögerungsschaltkreis (1) des Weiteren Folgendes umfasst:
- einen Flankenkomparator (8), der durch einen Flipflop (9) gebildet wird, der einen Takteingang (7) aufweist, der das verzögerte Taktsignal (CLK') empfängt, das durch einen Taktausgang (58) der einstellbaren Verzögerungsleitung (5) ausgegeben wird, und einen Dateneingang (10) aufweist, der das Datensignal (Daten) empfängt, und
- einen Phasenmargensicherheitsschaltkreis (12) zum Bereitstellen einer Phasenmargensicherheit gegen Taktjitter des empfangenen Taktsignals (CLK), wobei der Phasenmargensicherheitsschaltkreis (12) eine zuvor festgelegte Anzahl von Flipflops (13-i) umfasst, die miteinander in Reihe geschaltet sind,
wobei der erste Flipflop (13-1) des Phasenmargensicherheitsschaltkreises (12) mit einem Ausgang (11) des Flipflops (9) des Flankenkomparators (8) verbunden ist, wobei das empfangene Taktsignal (CLK) durch die einstellbare Verzögerungsleitung (5) mit einer zunehmenden Zeitverzögerung verzögert wird, die proportional zu dem inkrementierten n-Bit-Zählerwert ist, der durch den Taktflankenzähler (4) ausgegeben wird, bis der Flankenkomparator (8) detektiert, dass eine ansteigende Signalflanke des empfangenen Datensignals (Daten) einer ansteigenden Signalflanke des verzögerten Taktsignals (CLK') vorausgeht, das durch den Taktausgang (58) der einstellbaren Verzögerungsleitung (5) ausgegeben wird, einschließlich einer Zeitmarge, die durch den Phasenmargensicherheitsschaltkreis (12) bereitgestellt wird.

2. Selbsteinstellender Verzögerungsschaltkreis nach Anspruch 1, wobei der Taktflankenzähler (4) ein Welligkeitszähler ist, der eine zuvor festgelegte Anzahl (n) von Flipflops (27-i) umfasst, die miteinander in Reihe geschaltet sind.

3. Selbsteinstellender Verzögerungsschaltkreis nach Anspruch 1 oder 2, wobei die Inverter (50-1, 50-2, 50-3, 50-4) der einstellbaren Verzögerungsleitung (5) Drei-Zustands-Inverters sind, von denen jeder durch ein Bit des n-Bit-Zählerwertes aktiviert wird, das durch den Taktflankenzähler (4) ausgegeben wird, der dafür ausgelegt ist, das empfangene Taktsignal (CLK) mit einer Ansteuerungsstromstärke zu invertieren, die der Wertigkeit des jeweiligen Aktivierungs-Bits entspricht.

4. Selbsteinstellender Verzögerungsschaltkreis nach einem der vorangehenden Ansprüche 1 bis 3, der einen Rücksetzungsdetektorschaltkreis (23) umfasst, der dafür ausgelegt ist, in Reaktion auf ein Rücksetzsignal (RST) einen einzelnen Impuls zu generieren, um Flipflops des Taktflankenzählers (4) zu setzen.

5. Selbsteinstellender Verzögerungsschaltkreis nach einem der vorangehenden Ansprüche 1 bis 4, der einen Taktflankendetektorschaltkreis (17) umfasst, der dafür ausgelegt ist, abfallende Signalflanken des empfangenen Taktsignals (CLK) zu detektieren.

6. Selbsteinstellender Verzögerungsschaltkreis nach Anspruch 5, wenn von Anspruch 4 abhängig, wobei der Rücksetzungsdetektorschaltkreis (23) und der Taktflankendetektorschaltkreis (17) über ein OR-Gatter (22) mit einem Takteingang (25) des Taktflankenzählers (4) verbunden sind.

7. Selbsteinstellender Verzögerungsschaltkreis nach einem der vorangehenden Ansprüche 1 bis 6, wobei der Ausgang (11) des Flankenkomparators (8) gesetzt wird, wenn die ansteigende Signalflanke des empfangenen Datensignals (Daten) vor einer ansteigenden Signalflanke des verzögerten Taktsignals (CLK') erscheint, das durch die einstellbare Verzögerungsleitung (5) ausgegeben wird.

8. Selbsteinstellender Verzögerungsschaltkreis nach einem der vorangehenden Ansprüche 5 und 6 oder nach Anspruch 7, wenn von einem der Ansprüche 5 bis 6 abhängig,
wobei der Flankenkomparator (8) dafür ausgelegt ist, den Taktflankendetektorschaltkreis (17) direkt oder über den Phasenmargensicherheitsschaltkreis (12) zu deaktivieren, sobald die ansteigende Signalflanke des empfangenen Datensignals der ansteigenden Signalflanke des verzögerten Taktsignals (CLK') vorausgeht, das durch die einstellbare Verzögerungsleitung (5) ausgegeben wird.

9. Selbsteinstellender Verzögerungsschaltkreis nach einem der vorangehenden Ansprüche 1 bis 8, wobei das empfangene Datensignal (Daten) direkt oder über einen Pufferschaltkreis (36) des selbsteinstellenden Verzögerungsschaltkreis (1) weitergeleitet wird.

10. Selbsteinstellender Verzögerungsschaltkreis nach einem der vorangehenden Ansprüche 1 bis 9, wobei der Taktflankenzähler (4), der Flankenkomparator (8) und der Phasenmargensicherheitsschaltkreis (12) die gleiche Art von Flipflops umfassen.

11. Selbsteinstellender Verzögerungsschaltkreis nach Anspruch 10, wobei die Flipflops des Taktflankenzählers (4), des Flankenkomparators (8) und des Phasenmargensicherheitsschaltkreises (12) D-Flipflops umfassen.

12. Delay Locked Loop (DLL)-Schaltkreis, der einen selbsteinstellenden Verzögerungsschaltkreis (1) nach einem der vorangehenden Ansprüche 1 bis 11 umfasst.

## Revendications

1. Circuit à retard à auto-ajustement (1) conçu pour retarder un signal d'horloge reçu (CLK) fourni pour un signal de données reçu (données),
ledit circuit à retard à auto-ajustement (1) comprenant :
un compteur de fronts d'horloge (4) conçu pour compter des fronts de signal du signal d'horloge reçu (CLK) fournissant une valeur de compteur à n¬bits incrémentée au niveau de bornes de sortie (28-i) connectées à des entrées correspondantes (29-i) d'une ligne à retard réglable (5) dudit circuit à retard à auto-ajustement (1) via des lignes de signal parallèles (30-i),
ladite ligne à retard réglable (5) ayant un nombre (n) d'inverseurs (50-i) étant connectés les uns aux autres en parallèle, dans lequel chaque inverseur (50-i) de ladite ligne à retard réglable (5) est activé par un bit associé de la valeur de compteur à n bits reçue à partir dudit compteur de fronts d'horloge (4) via les lignes de signal parallèles (30-i) pour inverser le signal d'horloge reçu (CLK) avec une intensité de courant d'attaque de l'inverseur (50-i) correspondant à l'importance du bit respectif de ladite valeur de compteur à n bits pour charger un condensateur (53) de ladite ligne à retard réglable (5) connectée aux sorties des inverseurs (50-i),
dans lequel l'intensité du courant d'attaque du i-ième inverseur (50-i) de ladite ligne à retard réglable (5) est 2ⁱ⁻ⁱ avec 1≤i≤n, ledit circuit à retard à auto-ajustement (1) comprenant en outre :
- un comparateur de fronts (8) formé par une bascule (9) ayant une entrée d'horloge (7) recevant le signal d'horloge retardé (CLK') délivré par une sortie d'horloge (58) de ladite ligne à retard réglable (5) et ayant une entrée de données (10) recevant le signal de données (données), et
- un circuit de sécurité de marge de phase (12) pour fournir une sécurité de marge de phase contre la gigue d'horloge du signal d'horloge reçu (CLK), ledit circuit de sécurité de marge de phase (12) comprenant un nombre prédéterminé de bascules (13-i) connectées en série les unes aux autres,
dans lequel la première bascule (13-1) dudit circuit de sécurité de marge de phase (12) est connectée à une sortie (11) de la bascule (9) dudit comparateur de fronts (8), dans lequel le signal d'horloge reçu (CLK) est retardé par ladite ligne à retard réglable (5) avec un retard temporel croissant proportionnel à la valeur de compteur à n bits incrémentée délivrée par ledit compteur de fronts d'horloge (4) jusqu'à ce que ledit comparateur de fronts détecte qu'un front de signal montant du signal de données reçu (données) précède un front de signal montant du signal d'horloge retardé (CLK') délivré par la sortie d'horloge (58) de ladite ligne à retard réglable (5) comprenant une marge temporelle fournie par ledit circuit de sécurité de marge de phase (12).

2. Circuit à retard à auto-ajustement selon la revendication 1, dans lequel le compteur de fronts d'horloge (4) est un compteur en cascade comprenant un nombre prédéterminé (n) de bascules (27-i) connectées en série les unes aux autres.

3. Circuit à retard à auto-ajustement selon la revendication 1 ou 2, dans lequel les inverseurs (50-1, 50-2, 50-3, 50-4) de la ligne à retard réglable (5) sont des inverseurs à trois états activés chacun par un bit de la valeur de compteur à n bits fournie par ledit compteur de fronts d'horloge (4), conçus pour inverser le signal d'horloge reçu (CLK) avec une intensité de courant d'attaque correspondant à l'importance du bit d'activation respectif.

4. Circuit à retard à auto-ajustement selon l'une des revendications précédentes 1 à 3, comprenant :
un circuit détecteur de réinitialisation (23) conçu pour générer en réponse à un signal de réinitialisation (RST) une impulsion unique pour mettre à 1 des bascules dudit compteur de fronts d'horloge (4).

5. Circuit à retard à auto-ajustement selon l'une des revendications précédentes 1 à 4, comprenant :
un circuit détecteur de fronts d'horloge (17) conçu pour détecter des fronts de signal descendants du signal d'horloge reçu (CLK).

6. Circuit à retard à auto-ajustement selon la revendication 5, dépendant de la revendication 4,
dans lequel le circuit détecteur de réinitialisation (23) et le circuit détecteur de fronts d'horloge (17) sont connectés via une porte OU (22) à une entrée d'horloge (25) dudit compteur de fronts d'horloge (4).

7. Circuit à retard à auto-ajustement selon l'une des revendications précédentes 1 à 6,
dans lequel la sortie (11) dudit comparateur de fronts (8) est mise à 1 si le front de signal montant du signal de données reçu (données) apparaît avant un front de signal montant du signal d'horloge retardé (CLK') délivré par la ligne à retard réglable (5).

8. Circuit à retard à auto-ajustement selon l'une des revendications précédentes 5 à 6 ou selon la revendication 7, dépendant de l'une des revendications 5 à 6,
dans lequel ledit comparateur de fronts (8) est conçu pour désactiver directement ou via ledit circuit de sécurité de marge de phase (12) le circuit détecteur de fronts d'horloge (17) dès que le front de signal montant du signal de données reçu précède le front de signal montant du signal d'horloge retardé (CLK') délivré par ladite ligne à retard réglable (5).

9. Circuit à retard à auto-ajustement selon l'une des revendications précédentes 1 à 8,
dans lequel le signal de données reçu (données) est transmis directement ou via un circuit tampon (36) dudit circuit à retard à auto-ajustement (1).

10. Circuit à retard à auto-ajustement selon l'une des revendications précédentes 1 à 9,
dans lequel ledit compteur de fronts d'horloge (4), ledit comparateur de fronts (8) et ledit circuit de sécurité de marge de phase (12) comprennent le même type de bascules.

11. Circuit à retard à auto-ajustement selon la revendication 10, dans lequel les bascules dudit compteur de fronts d'horloge (4), dudit comparateur de fronts (8) et dudit circuit de sécurité de marge de phase (12) comprennent des bascules D.

12. Circuit à boucle à verrouillage de retard (DLL) comprenant un circuit à retard à auto-ajustement (1) selon l'une des revendications précédentes 1 à 11.
